# EUROPEAN PATENT APPLICATION

(11) **EP 4 799 847 A1**
(43) Date of publication of application: **02.09.2026**
(21) Application number: 26161683.3
(22) Date of filing: 02.03.2026
(51) Int. Cl.: B60K 35/231, B60K 35/53, B60K 35/60, B60R 11/02

(54) **COMPONENT WITH MOVABLE DISPLAY DEVICE AND COCKPIT COMPONENT**

(30) Priority: 28.02.2025 CN 202520349531 U
(71) Applicant: Faurecia Automotive Interior System (Shanghai) Co., Ltd., Shanghai 201109 (CN)
(72) Inventor: CHENG, Shiqi, Shanghai (CN); GONG, Bo, Shanghai (CN); SHANG, Hao, Shanghai (CN)
(74) Representative: Pfenning, Meinig & Partner mbB

(57) **Abstract**

The present disclosure relates to a component (100) with a movable display device and a cockpit component. The component (100) includes a base (1), wherein the base (1) provides a storage space (11), and the storage space (11) has an opening (111); a cover assembly (2), being capable of opening or closing the opening (111), wherein the cover assembly (2) includes a first cover (21) and a second cover (22) arranged adjacent to each other in a length direction, and the first cover (21) being able to correspondingly cover a first area (1111) of the opening, and the second cover (22) being able to correspondingly cover a second area (1112) of the opening; a movable display device (3); wherein, the component (100) has a first state (101) and a second state (102);in the first state (101), the first cover (21) covers the first area (1111) of the opening, the second cover (22) covers the second area (1112) of the opening, and the movable display device (3) is located inside the storage space (11) and is non-visible.

## Description

### Field

The present disclosure relates to a component with a movable display device and a cockpit component.

### Background

At present, in a cockpit of a vehicle, such as an automobile cockpit, a large screen, e.g., a 15.6-inch large screen, is often provided to offer a user an experience of audio-visual interaction and entertainment, so as to improve user experience.

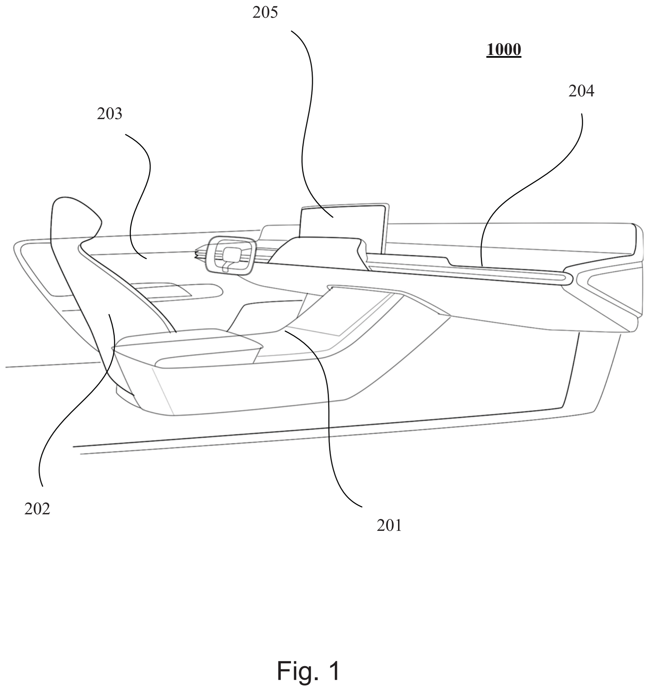

However, in current solutions, the large screen is generally fixedly arranged in the cockpit. For example, as shown in FIG. 1, the cockpit component includes a center console 201, a seat 202, a door panel 203, and an instrument panel 204, and the large screen, as a display device 205, is fixed to the instrument panel, which occupies a large space and affects the space arrangement in the cockpit. In particular, the large screen is generally located at the position of the instrument panel 204, occupying a large space, and further affecting the space arrangement of the cockpit.

Therefore, there is a need for a component with a movable display device and a cockpit component, being able to minimize occupation of usage space on the basis of realizing a stably and reliably arranged large screen, so as to facilitate space arrangement in the cockpit.

### Summary

An object of the present disclosure is to provide a component with a movable display device.

An object of the present disclosure is to provide a cockpit component.

A component with a movable display device according to a first aspect of the present disclosure includes: a base, wherein the base provides a storage space, and the storage space has an opening; a cover assembly capable of opening or closing the opening, wherein the cover assembly includes a first cover and a second cover arranged adjacent to each other in a length direction, the first cover is capable of correspondingly covering a first area of the opening, and the second cover is capable of correspondingly covering a second area of the opening; a movable display device; wherein the component has a first state and a second state; in the first state, the first cover covers the first area of the opening, the second cover covers the second area of the opening, and the movable display device is located inside the storage space and is non-visible; in the second state, the first cover moves along the length direction to one end of the opening such that the first area is opened, the second cover flips around an axis located at the other end of the opening such that the second area is opened, and the movable display device passes through the opening between the one end and the other end and protrudes out of the storage space.

The beneficial effects are as follows: by means of the structural arrangement that the first cover moves along the length direction to the first end of the opening such that the first area is opened, the second cover flips around an axis located at the second end of the opening such that the second area is opened, and the movable display device passes through the opening between the first end and the second end and protrudes out of the storage space, the display device can be hidden and placed in the storage space and become non-visible when not in use, so as to reduce occupation of usage space. On this basis, by providing a plurality of covers, and employing a structure in which the first cover moves toward one end to open and the second cover flips toward the other end to open, the covers can be opened quickly when the display device needs to be used, so that the display device moves rapidly to protrude out of the opening. Moreover, reliable placement of brackets and other components attached to the display device can be realized when the display device protrudes out of the opening in a use state, so as to provide an experience of a stably and reliably arranged large screen.

In one or more embodiments of the component, it further includes a first driving assembly, including: a slider portion and a slide rail portion, wherein the slider portion and the slide rail portion are slidably matched, and one of the slider portion and the slide rail portion is arranged on the base, and the other is arranged on the first cover, such that the first cover is movable along the length direction.

In one or more embodiments of the component, the slider portion is arranged on the first cover, and the slide rail portion is arranged on the base. The slider portion includes a first slider and a second slider respectively located on both side edges of the first cover in a width direction, and a third slider and a fourth slider located on one side edge of the first cover in the length direction. A width between the first slider and the second slider is a first width, and a width between the third slider and the fourth slider is a second width, wherein the first width is greater than the second width. The slide rail portion includes a first slide rail corresponding to the first slider, a second slide rail corresponding to the second slider, a third slide rail corresponding to the third slider, and a fourth slide rail corresponding to the fourth slider.

In one or more embodiments of the component, the first driving assembly further includes a nut member, a motor and a screw rod, wherein the nut member is arranged on the first cover, the motor is arranged on the base, an output of the motor is transmitted to the screw rod, and the screw rod cooperates with the nut member to drive the first cover to move along the length direction.

In one or more embodiments of the component, the first driving assembly further includes a limit switch. When the first cover moves along the length direction to one end of the opening such that the first area is opened, the limit switch is triggered to stop the motor.

In one or more embodiments of the component, it further includes a second driving assembly, including: a motor and a transmission assembly, wherein the motor and the transmission assembly are arranged adjacent to each other in a height direction, and the motor is mounted and fixed to the base through a bracket; the transmission assembly includes a first transmission wheel, a transmission belt and a second transmission gear, the second transmission gear is coaxially connected to a shaft, the shaft provides the axis, rotation output by the motor is transmitted to the first transmission wheel via the transmission belt, and the first transmission wheel transmits the rotation to the second transmission gear through gear meshing, so as to drive the second cover to flip around the axis.

In one or more embodiments of the component, the transmission assembly further includes an intermediate transmission gear, wherein the first transmission wheel meshes with the intermediate transmission gear, and the intermediate transmission gear meshes with the second transmission gear.

In one or more embodiments of the component, the second driving assembly is arranged on both sides of the second cover in the width direction.

In one or more embodiments of the component, it further includes a third driving assembly, the third driving assembly being connected to the movable display device. The third driving assembly includes a first motor, a second motor, a first movable slide rail and a second movable slide rail, wherein the first motor is capable of driving the movable display device to move by a first height in the height direction, and the second motor is capable of driving the second movable slide rail to move by a second height in the height direction relative to the first movable slide rail. The third driving assembly further includes a third motor and a fourth motor, wherein the third motor is connected to the movable display device and is capable of driving the movable display device to rotate around an axis extending in the length direction, and the fourth motor is connected to the movable display device and is capable of driving the movable display device to rotate around an axis extending in the width direction.

A cockpit component according to a second aspect of the present disclosure includes the component with a movable display device according to the first aspect, wherein the cockpit component includes a center console, a seat, a door panel and an instrument panel.

### Description of attached drawings

The above and other features, properties, and advantages of the present disclosure will become more apparent through the following description in conjunction with the accompanying drawings and embodiments, where:
FIG. 1 is a schematic structural diagram of the structure of a cockpit structure of a vehicle of prior art.
FIG. 2A is a schematic structural diagram of a component with a movable display device in a first state according to an embodiment.
FIG. 2B is a schematic structural diagram of the component with a movable display device in a second state according to an embodiment.
FIG. 3 is a schematic structural diagram of the component with a movable display device with a first cover opened according to an embodiment.
FIGS. 4A, 4B, 4C, 4D and 4E are schematic structural diagrams of the first cover and a first driving assembly of the component with a movable display device according to an embodiment, respectively.
FIG. 5 is a schematic structural diagram of the component with a movable display device with a second cover opened according to an embodiment.
FIGS. 6A and 6B are schematic structural diagrams of the second cover and a second driving assembly of the component with a movable display device according to an embodiment, respectively.
FIGS. 7A, 7B, 7C and 7D are schematic structural diagrams of the display device and a third driving assembly of the component with a movable display device according to an embodiment, respectively.

### Reference Numerals:

1000 - cockpit
100 - component with a movable display device
101 - first state
102 - second state
1 - base
11 - storage space
111 - opening
1111 - first area
1112 - second area
1113 - one end
1114 - other end
12 - shaft
121 - axis
2 - cover assembly
21 - first cover
22 - second cover
3 - movable display device
41 - first driving assembly
411 - slider portion
4111 - first slider
4112 - second slider
4113 - third slider
4114 - fourth slider
412 - slide rail portion
4121 - first slide rail
4122 - second slide rail
4123 - third slide rail
4124 - fourth slide rail
413 - nut member
414 - motor
415 - screw rod
416 - limit switch
42 - second driving assembly
421 - motor
422 - transmission assembly
4221 - first transmission wheel
4222 - transmission belt
4223 - second transmission gear
4224 - intermediate transmission gear
43 - third driving assembly
431 - first motor
432 - second motor
433 - first movable slide rail
434 - second movable slide rail
435 - third motor
436 - fourth motor
201 - center console
202 - seat
203 - door panel
204 - instrument panel
205 - display device

### Detailed Description of Embodiments

Hereinafter, embodiments of the technical solution of the present disclosure will be described in detail with reference to the drawings. And embodiments are merely used to more clearly explain the technical solution of the present disclosure, and therefore are merely examples, and should not limit the scope of protection of the present disclosure.

Unless otherwise defined, all technical and scientific terms used herein have the same meaning as commonly understood by those skilled in the art of the present disclosure. The terms used herein are for the purpose of describing embodiments only and not intended to limit the present disclosure; The terms "including" and "having" and any variations thereof in the specification and claims of the present disclosure and the above description of drawings are intended to cover non-exclusive inclusions.

In the embodiments of the present disclosure, the technical terms "first", "second" and the like are only used to distinguish different objects, and should not be understood to indicate or imply relative importance or implicitly indicate the number, specific order, or primary-secondary relationship of the indicated technical features. In the embodiments of the present disclosure, "a plurality" means two or more unless otherwise explicitly and specifically defined.

An "embodiment" means that a particular feature, structure, or characteristic described may be included in at least one embodiment of the present disclosure. The appearance of the word "embodiment" in various places in the specification does not necessarily refer to the same embodiment, nor refer to an independent or alternative embodiment that is mutually exclusive from other embodiments. It may be explicitly and implicitly understood by those skilled in the art that the embodiments described herein may be combined with other embodiments.

In the embodiments of the present disclosure, the technical terms such as "center", " longitude", " latitude", "length", "width", "thickness", "upper", "lower", "front", "rear", "left", "right", "vertical", "horizontal", "top", "bottom", "inner", "outer", "clockwise", "counterclockwise", "axial", "radial", "circumferential" and the like are based on the orientation or positional relationships shown in the drawings, and are merely used to facilitate and simplify the description of the embodiments of the present disclosure, and do not indicate or imply that the referred device or element must have a specific orientation, be constructed and operated in a specific orientation, and therefore cannot be understood as a limitation of the embodiments of the present disclosure.

In the embodiments of the present disclosure, unless otherwise explicitly specified and defined, technical terms such as "mounted", "linked", "connected" and "fixed" should be understood in a broad sense, for example, they may be fixed connected, detachable connected, or integrated; It may also be a mechanical connection, and those skilled in the art can understand the specific meanings of the above terms in the embodiments of the present disclosure according to specific circumstances.

Although the component with a movable display device disclosed in the embodiments of the present disclosure is suitable for a center console of an automobile, it is not limited thereto. For example, it can be applied to other vehicle applications, such as railway transportations, ships, airplanes, etc., and is not limited to vehicles. For example, it can also be applied to a fixed place, such as a massage chair, a venue, an auditorium, an office seat and other scenarios corresponding to a movable display device. The component with a movable display device and the cockpit component disclosed in the embodiments can be applied as long as a stably and reliably arranged large screen is provided and occupation of usage space is minimized to facilitate space arrangement in the cockpit.

The length direction, width direction and height direction described below can be X-direction, Y-direction and Z-direction which are mutually perpendicular as shown in the figures, but are not limited thereto.

As can be seen with reference to FIG. 1, different from the center console 201, seat 202, door panel 203 and instrument panel 204 of a conventional cockpit 1000, the cockpit component with the component 100 with a movable display device described in the embodiments has a movable display device 3 instead of the fixed display device 205 shown in FIG. 1. That is, the center console 201, seat 202, door panel 203 and instrument panel 204 shown in FIG. 1 can be integrated with the movable display device 3. The description of the following embodiments and the representation of the drawings take the center console 201 having the movable display device 3 as an example, but are not limited thereto.

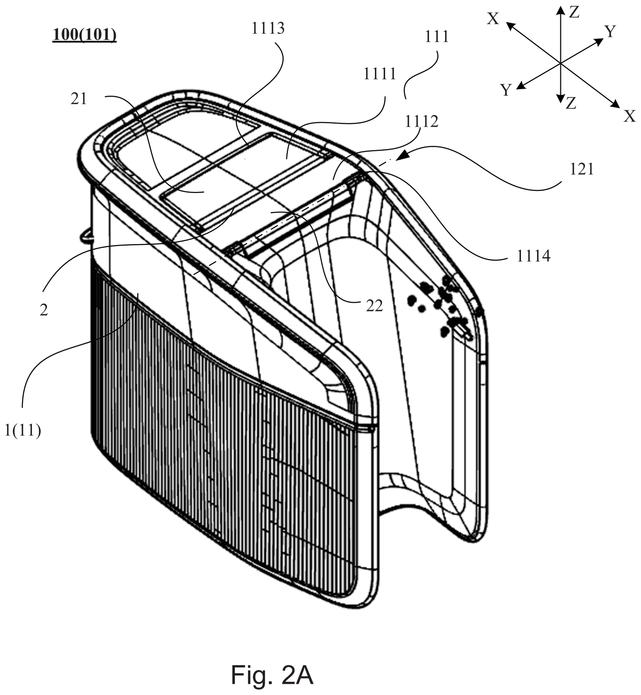

Referring to FIGS. 2A to 7D, in some embodiments, the component 100 with a movable display device includes a base 1, a cover assembly 2 and a movable display device 3.

The base 1 can be, for example, a box body of an armrest box of the center console as shown in the figures, but is not limited thereto. The base 1 provides a storage space 11, and the storage space 11 has an opening 111.

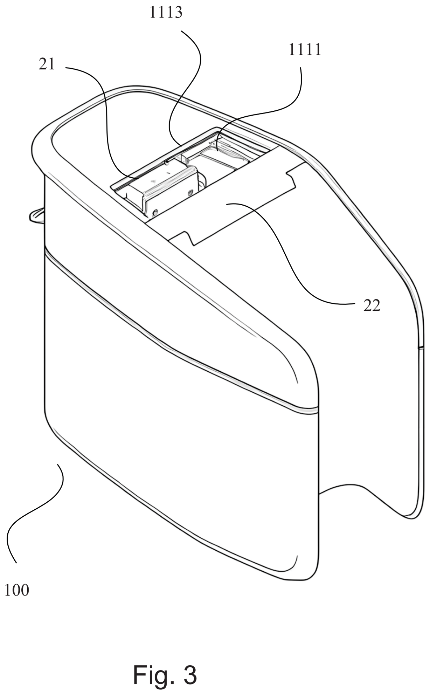

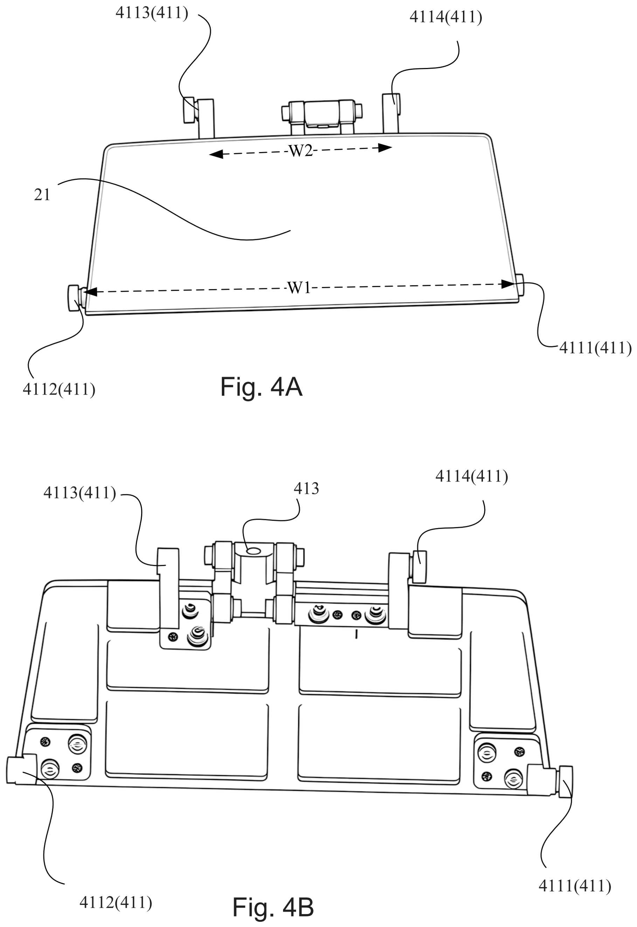

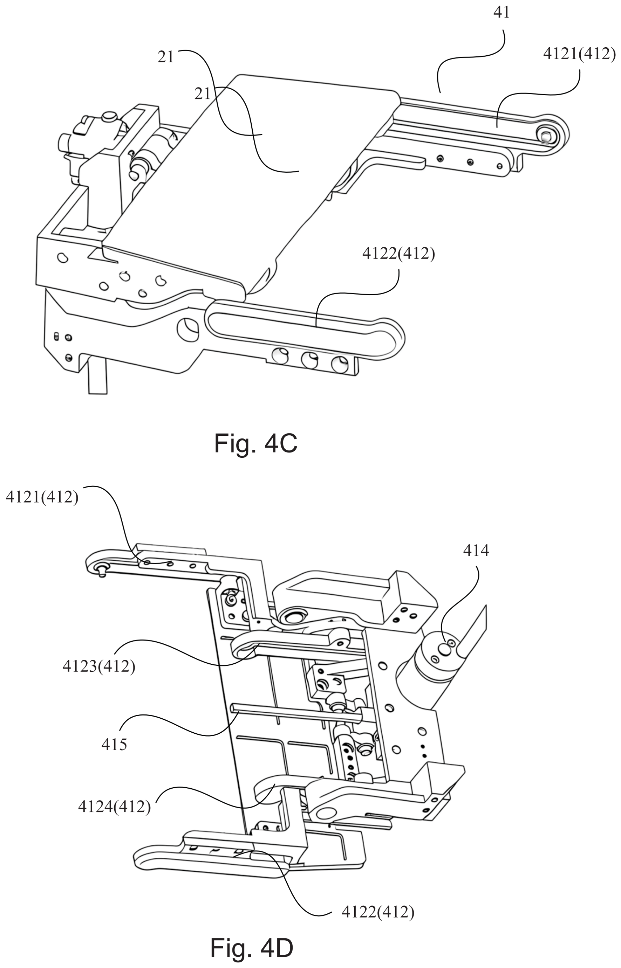

The cover assembly 2 is capable of opening or closing the opening 111. The cover assembly 2 includes a first cover 21 and a second cover 22 arranged adjacent to each other in the length direction. As shown in FIG. 3 and FIGS. 4A to 4E, the first cover 21 is capable of correspondingly covering a first area 1111 of the opening, and the second cover 22 is capable of correspondingly covering a second area 1112 of the opening.

The meaning of the movable display device 3 is relative to the fixed display device 205 shown in FIG. 1. The movable display device 3 means that the position of the display device 3 is able to move in the Z-direction during use, and is able to also rotate in the X-direction or Y-direction on this basis. In some embodiments, detailed structure will be described below.

The movable display device 3 is formed, for example, by a touch screen, which is a screen capable of controlling one or more functions of the vehicle or devices connected to the movable display device 3. For this purpose, the movable display device 3 can, for example, be covered with a capacitive film connected to a vehicle control device, or any other component that allows a user to interact with the display area by touching and/or approaching the movable display device 3 with a finger. Therefore, the user can interact with the movable display device 3 to control one or more functions of the vehicle, for example, to control an air conditioning system and/or an audio system and/or to change the display content of the display area 20. The movable display device 3 can also be arranged to allow control of one or more functions of a device connected to the display device, and/or to control or set parameters for audio-visual content displayed on the movable display device 3. The connection of a device, such as a portable electronic device such as a mobile phone or a smart phone, can be performed in any known manner, through a wireless connection or other methods. Such a portable electronic device can be received in the vicinity of the movable display device 3, for example.

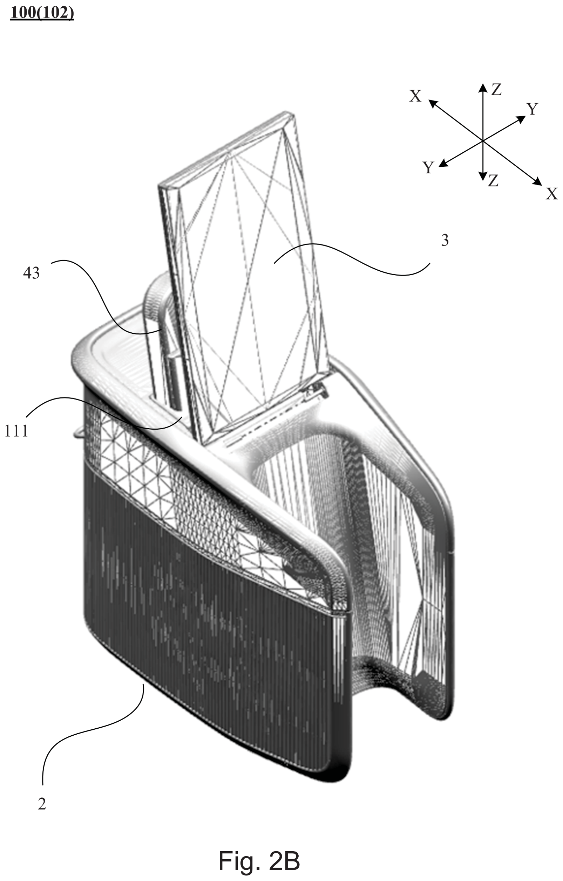

Referring to FIGS. 2A and 2B, the component 100 has a first state 101 and a second state 102.

As shown in FIG. 2A, in the first state 101, the first cover 21 covers the first area 1111 of the opening, the second cover 22 covers the second area 1112 of the opening, and the movable display device 3 is located inside the storage space 11 and is non-visible.

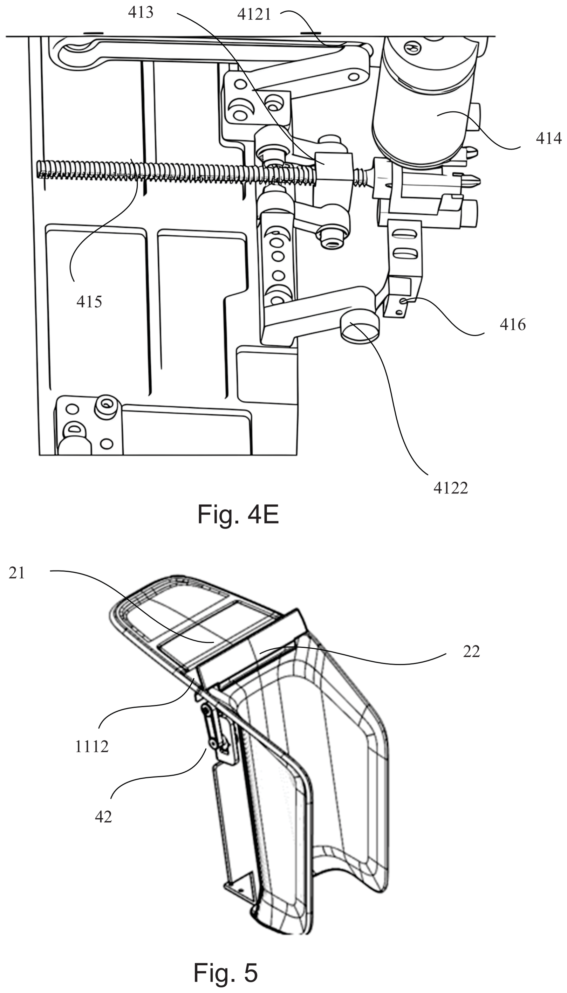

As shown in FIG. 2B, FIG. 3 and FIG. 5, in the second state 102, the first cover 21 moves along the length direction to one end 1113 of the opening such that the first area 1111 is opened, the second cover 22 flips around an axis 121 located at the other end 1114 of the opening such that the second area 1112 is opened, and the movable display device 3 passes through the opening 111 between the one end 1113 and the other end 1114 and protrudes out of the storage space 11. It can be understood that FIG. 3 and FIG. 5 respectively show the structure in which the first cover 21 is opened and the second cover 22 is opened for clearer illustration, but in the second state 102, the first cover 21 and the second cover 22 are opened at the same time. For example, in the X-direction in the figures, the first cover 21 is translationally opened to the left, and the second cover 22 is rotationally opened to the right.

The beneficial effects are as follows: by means of the structural arrangement that the first cover moves along the length direction to the first end of the opening such that the first area is opened, the second cover flips around an axis located at the second end of the opening such that the second area is opened, and the movable display device passes through the opening between the first end and the second end and protrudes out of the storage space, the display device can be hidden and placed in the storage space and become non-visible when not in use, so as to reduce occupation of usage space. On this basis, by providing a plurality of covers, and employing a structure in which the first cover moves toward one end to open and the second cover flips toward the other end to open, the covers can be opened quickly when the display device needs to be used, so that the display device moves rapidly to protrude out of the opening. Moreover, reliable placement of brackets and other components attached to the display device can be realized when the display device protrudes out of the opening in a use state, so as to provide an experience of a stably and reliably arranged large screen.

Referring to FIGS. 4A to 4E, in some embodiments, the structure for realizing movement of the first cover 21 along the length direction can be as follows: the first driving assembly 41 includes a slider portion 411 and a slide rail portion 412, wherein the slider portion 411 and the slide rail portion 412 are slidably matched, and one of the slider portion 411 and the slide rail portion 412 is arranged on the base 1, and the other is arranged on the first cover 21, such that the first cover 21 is movable along the length direction. By employing a sliding fit formed by slide rails and sliders, the translational structure can be smooth and stable, and the moving mechanism can be easily hidden to provide a good visual appearance.

With continued reference to FIGS. 4A to 4E, in some embodiments, the sliding structure can be as follows: the slider portion 411 is arranged on the first cover 21, and the slide rail portion 412 is arranged on the base 1. The slider portion 411 includes a first slider 4111 and a second slider 4112 respectively located on both side edges of the first cover 21 in the width direction, and a third slider 4113 and a fourth slider 4114 located on one side edge of the first cover 21 in the length direction. A width between the first slider 4111 and the second slider 4112 is a first width W1, and a width between the third slider 4113 and the fourth slider 4114 is a second width W2, wherein the first width W1 is greater than the second width W2. The slide rail portion 412 includes a first slide rail 4121 corresponding to the first slider 4111, a second slide rail 4122 corresponding to the second slider 4112, a third slide rail 4123 corresponding to the third slider 4113, and a fourth slide rail 4124 corresponding to the fourth slider 4114. The beneficial effects are as follows: by employing two pairs of symmetrically arranged slide rail and slider structures on both sides, the structure is relatively stable, the accuracy of the movement position can be easily controlled, the shaking and possible noise during movement are reduced, and furthermore, the structure in which the first width W1 is greater than the second width W2 further improves the stability of the sliding fit.

With continued reference to FIGS. 4D and 4E, in some embodiments, the structure for driving the first cover 21 to move can be as follows: the first driving assembly 41 further includes a nut member 413, a motor 414 and a screw rod 415, wherein the nut member 413 is arranged on the first cover 21, the motor 414 is arranged on the base 1, an output of the motor 414 is transmitted to the screw rod 415, and the screw rod 415 cooperates with the nut member 413 to drive the first cover 21 to move along the length direction. By employing a screw motor driving scheme with screw-nut fit, the motor has high output efficiency, low cost and compact structure, and the stroke can be accurately controlled.

With continued reference to FIG. 4E, in some embodiments, the first driving assembly 41 further includes a limit switch 416. When the first cover 21 moves along the length direction to one end 1113 of the opening such that the first area 1111 is opened, the limit switch 416 is triggered to stop the motor 414. The limit switch 416 herein has a similar meaning to that in the electrical control field, that is, the limit switch is used to detect sequence control, positioning control and position status, so as to control the stroke and limit protection of mechanical equipment. The limit switch, also known as a stroke switch, can be mounted on a relatively stationary object (such as a fixed frame, a door frame, etc.) or a moving object (such as a vehicle, a door, etc.). When the moving object approaches the stationary object, a connecting rod of the switch drives a contact of the switch, thereby closing or opening contact. The circuit and the motor are controlled by the change of the connection and disconnection states of the switch contact. In the actual production process, the limit switch is installed at a preset position. When a module mounted on a moving component encounters the limit switch, the contact of the limit switch moves, thereby realizing switching of the circuit. Therefore, the stroke switch is an electrical appliance that switches the circuit according to the stroke position of the moving component, and its working principle is similar to that of a button. The employment of the limit switch is able to make the whole movement process stable and accurate, the speed can be configured as required, the accuracy and reliability of the movement stroke of the first cover 21 are further improved, and safety is ensured by preventing exceeding the stroke.

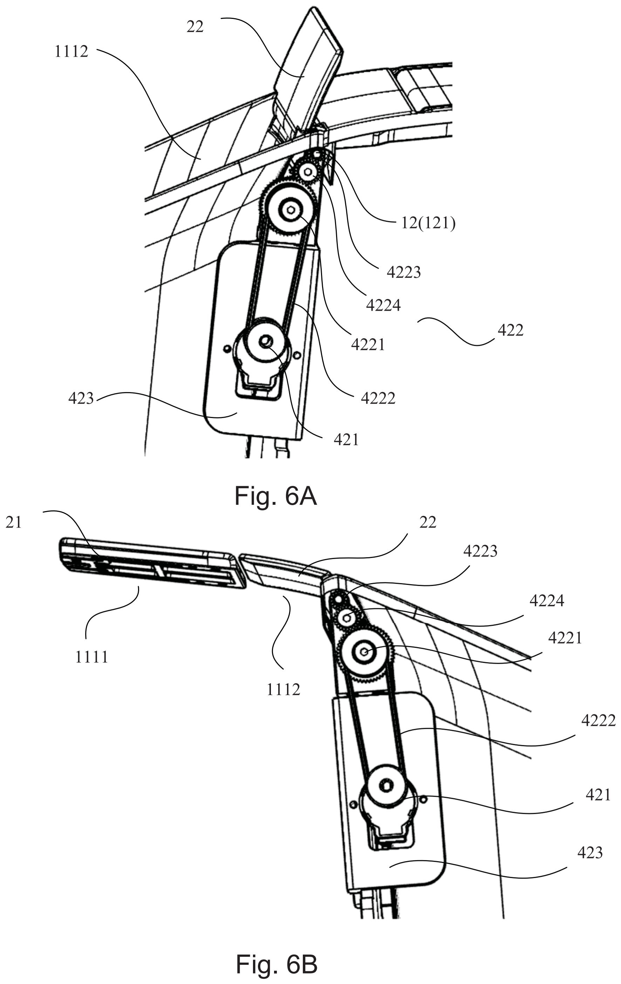

Referring to FIG. 5, FIG. 6A and FIG. 6B, in some embodiments, the structure for realizing rotational opening of the second cover 22 can be as follows: the second driving assembly 42 includes a motor 421 and a transmission assembly 422, wherein the motor 421 and the transmission assembly 422 are arranged adjacent to each other in the height direction, and the motor 421 is mounted and fixed to the base 1 through a bracket 423; the transmission assembly 422 includes a first transmission wheel 4221, a transmission belt 4222 and a second transmission gear 4223, the second transmission gear 4223 is coaxially connected to a shaft 12, the shaft 12 provides an axis 121, rotation output by the motor 421 is transmitted to the first transmission wheel 4221 via the transmission belt 4222, and the first transmission wheel 4221 transmits the rotation to the second transmission gear 4223 through gear meshing, so as to drive the second cover 22 to flip around the axis 121. By employing a transmission path of motor-transmission belt pulley-synchronous transmission gear-transmission gear-shaft, the whole transmission structure can be compact and reliable. As shown in the figures, the components are stacked adjacent to each other in sequence in the height direction, occupying a small space, so that all components of the second driving assembly 42 can be hidden in a relatively deep position. Even if the second cover 22 is opened, a neat appearance can be maintained without seeing the internal structure. The rotatable second cover 22 can also be referred to as a flip cover, and the space covered by the flip cover can be used for storage, charging or other electrical equipment.

With continued reference to FIGS. 6A and 6B, the transmission assembly 422 can further include an intermediate transmission gear 4224, wherein the first transmission wheel 4221 meshes with the intermediate transmission gear 4224, and the intermediate transmission gear 4224 meshes with the second transmission gear 4223. By employing a three-stage transmission structure with the intermediate transmission gear, the flipping of the second cover 22 can be controlled more accurately, the gap between the second cover 22 and surrounding parts in the closed state can be controlled to be about 1 mm, and the internal mechanism cannot be seen when the second cover 22 is in the open and closed states.

With continued reference to FIG. 5, in some embodiments, the second driving assembly 42 is arranged on both sides of the second cover 22 in the width direction. Only the second driving assembly 42 on one side in the width direction is shown in FIG. 5, and actually the same second driving assembly 42 is also arranged on the other side in the width direction. The beneficial effects are as follows: the two second driving assemblies 42 can be further miniaturized, so as to better meet the requirements of a narrow installation space.

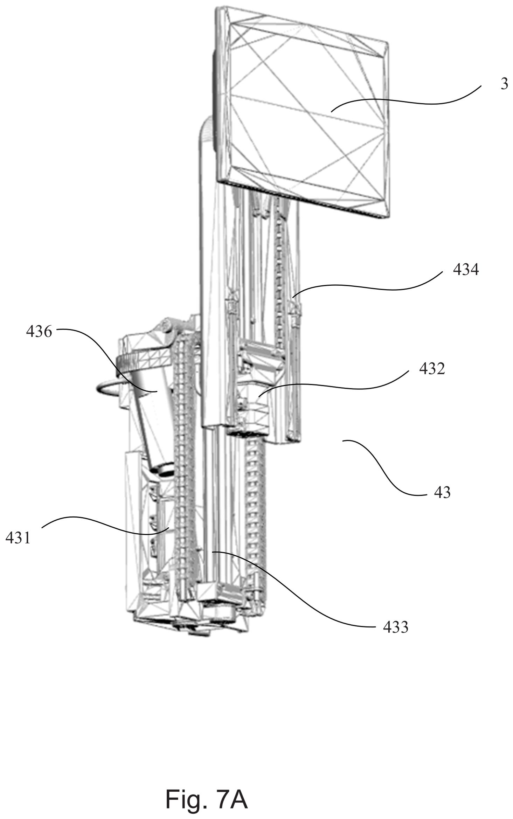

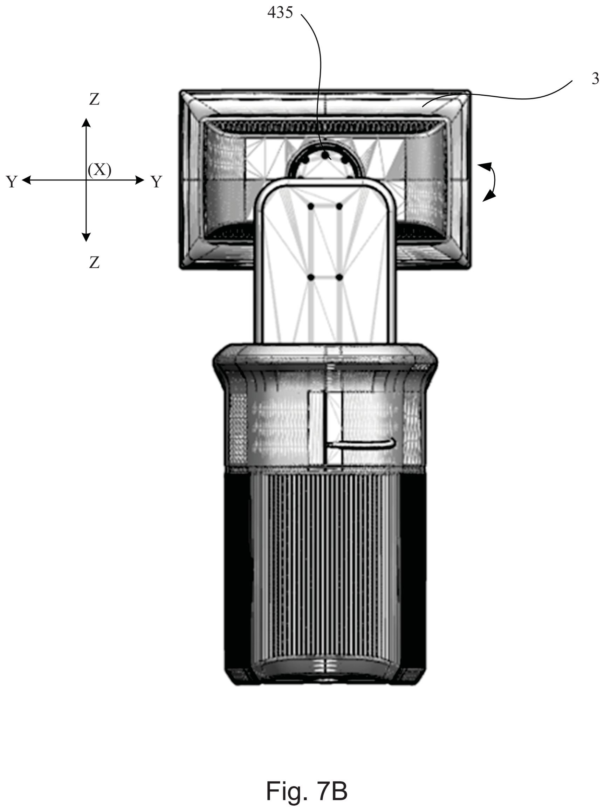

Referring to FIGS. 7A to 7D, in some embodiments, the structure for realizing movement of the display device 3 in the height direction can include a third driving assembly 43, the third driving assembly 43 being connected to the movable display device 3. The third driving assembly 43 includes a first motor 431, a second motor 432, a first movable slide rail 433 and a second movable slide rail 434, wherein the first motor 431 is capable of driving the movable display device 3 to move by a first height in the height direction, and the second motor 432 is capable of driving the second movable slide rail 434 to move by a second height in the height direction relative to the first movable slide rail 433. By employing a two-stage moving mechanism, the size of the mechanism can be reduced, and the mechanism is visually compact and space-saving. In some embodiments, it is generally required to lift the display device 3 by 300 mm-450 mm in the height direction, and the movement in the height direction is divided into two stages, which are respectively completed by two motors. As shown in FIGS. 7A and 7B, the first motor 431 is fixed to realize the first-stage movement in the height direction so that the third driving assembly 43 moves upward in the height direction as a whole, and the second motor 432 completes the second-stage movement in the height direction. The beneficial effects are as follows: first, an excessively long lifting stroke in the height direction tends to deteriorate the overall rigidity of the mechanism, and the segmentation can improve the rigidity of each segment; second, if the first motor 431 can be partially exposed, the mechanism is compact, the thickness can be only about 3 cm, and the appearance is neat; third, the stroke is long, and the two motors can work at the same time, so that the display device can quickly rise to a height desired by the user without generating extra noise due to an excessively high motor speed.

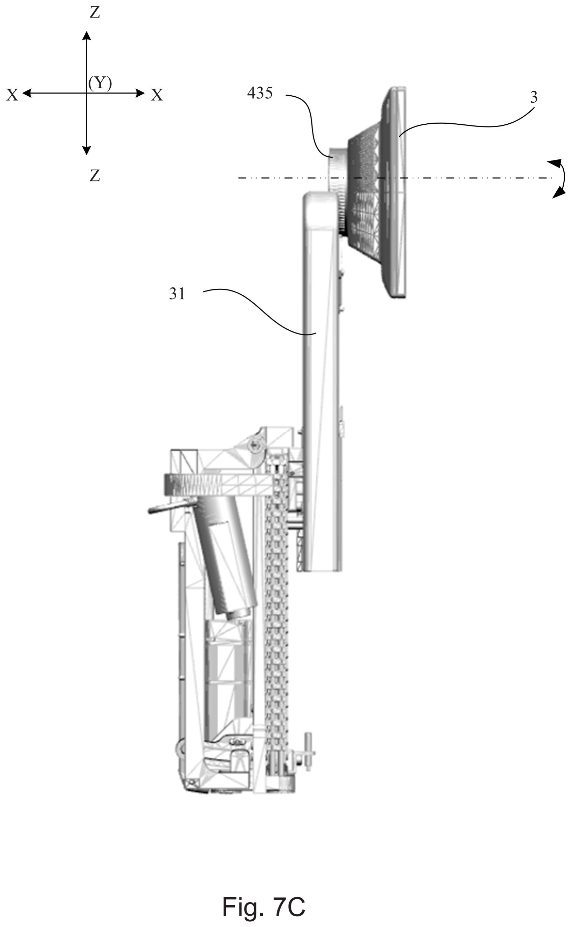

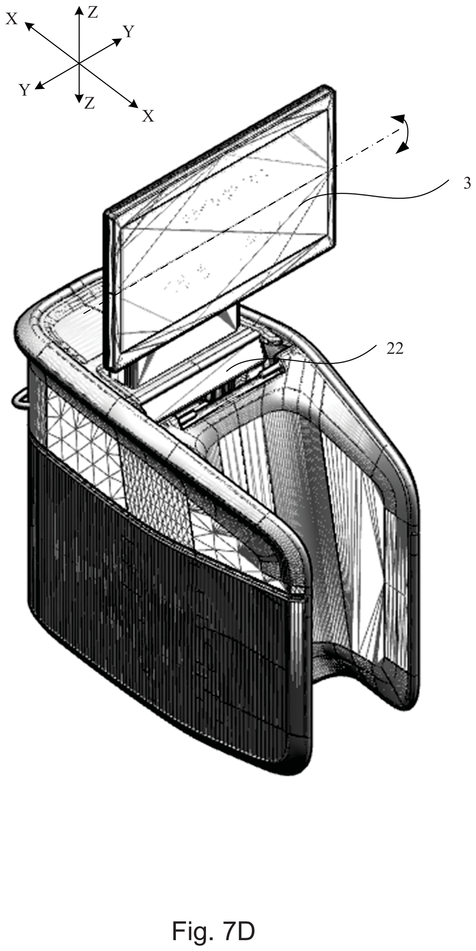

Referring to FIGS. 7B to 7D, the third driving assembly 43 can further include a third motor 435 and a fourth motor 436. As shown in FIGS. 7B and 7C, the third motor 435 is connected to the movable display device 3 and is capable of driving the movable display device 3 to rotate around an axis extending in the length direction, that is, the screen can be rotated by 90 degree to switch from an initial vertical screen state to a horizontal screen state, so as to meet the user's horizontal screen viewing mode in the vehicle. As shown in FIGS. 7A and 7D, the fourth motor 436 is connected to the movable display device 3 and is capable of driving the movable display device 3 to rotate around an axis extending in the width direction. In this way, the adjustment of the pitch angle of the screen of the display device can be realized, so as to adapt to users of different heights and different positions of the seat backrest, adjust the screen inclination angle, and provide a better human-machine design.

In summary, the beneficial effects of the component with a movable display device and the cockpit component employing the above embodiments include but are not limited to: by means of the structural arrangement that the first cover moves along the length direction to the first end of the opening such that the first area is opened, the second cover flips around an axis located at the second end of the opening such that the second area is opened, and the movable display device passes through the opening between the first end and the second end and protrudes out of the storage space, the display device can be hidden and placed in the storage space and become non-visible when not in use, so as to reduce occupation of usage space. On this basis, by providing a plurality of covers, and employing a structure in which the first cover moves toward one end to open and the second cover flips toward the other end to open, the covers can be opened quickly when the display device needs to be used, so that the display device moves rapidly to protrude out of the opening. Moreover, reliable placement of brackets 31 and other components attached to the display device can be realized when the display device protrudes out of the opening in a use state, so as to provide an experience of a stably and reliably arranged large screen.

Although the present disclosure is disclosed as above with embodiments, it is not intended to limit the present disclosure. Any person skilled in the art can make possible changes and modifications without departing from the spirit and scope of the present disclosure. Therefore, any modification, equivalent change, and modification made to the above embodiments according to the technical essence of the present disclosure without departing from the content of the technical solution of the present disclosure shall fall within the scope defined by the claims of the present disclosure.

## Claims

1. A component (100) with a movable display device, **characterized in that** it comprises:
a base (1), wherein the base (1) provides a storage space (11), and the storage space (11) has an opening (111);
a cover assembly (2), being capable of opening or closing the opening (111), wherein the cover assembly (2) comprises a first cover (21) and a second cover (22) arranged adjacent to each other in a length direction, and the first cover (21) being able to correspondingly cover a first area (1111) of the opening, and the second cover (22) being able to correspondingly cover a second area (1112) of the opening;
a movable display device (3);
wherein, the component (100) has a first state (101) and a second state (102);
in the first state (101), the first cover (21) covers the first area (1111) of the opening, the second cover (22) covers the second area (1112) of the opening, and the movable display device (3) is located inside the storage space (11) and is non-visible;
in the second state (102), the first cover (21) moves along the length direction to one end (1113) of the opening and the first area (1111) is opened, and the second cover (22) flips around an axis (121) located at the other end (1114) of the opening and the second area (1112) is opened, and the movable display device (3) passes through the opening (111) between the one end (1113) and the other end (1114) and protrudes from the storage space (11).

2. The component (100) according to claim 1, **characterized in that** it further comprises a first driving assembly (41), including: a slider portion (411) and a slide rail portion (412), wherein the slider portion (411) and the slide rail portion (412) are slidably matched, and one of the slider portion (411) and the slide rail portion (412) is arranged on the base (1), and the other one is arranged on the first cover (21), and the first cover (21) is able to move along the length direction.

3. The component (100) according to claim 2, **characterized in that** the slider portion (411) is arranged on the first cover (21), and the slide rail portion (412) is arranged on the base (1), and the slider portion (411) includes a first slider (4111) and a second slider (4112) respectively located on both side edges of the first cover (21) in a width direction, and a third slider (4113) and a fourth slider (4114) located on one side edge of the first cover (21) in the length direction, and a gap in the width direction between the first slider (4111) and the second slider (4112) is a first width (W1), and a gap in the width direction between the third slider (4113) and the fourth slider (4114) is a second width (W2), and the first width (W1) is greater than the second width (W2), and the slide rail portion (412) includes a first slide rail (4121) corresponding to the first slider (4111), a second slide rail (4122) corresponding to the second slider (4112), a third slide rail (4123) corresponding to the third slider (4113), and a fourth slide rail (4124) corresponding to the fourth slider (4114).

4. The component (100) according to claim 2, **characterized in that** the first driving assembly (41) further comprises a nut member (413), a motor (414) and a screw rod (415), wherein the nut member (413) is arranged on the first cover (21), the motor (414) is arranged on the base (1), an output of the motor (414) is transferred to the screw rod (415), and the screw rod (415) cooperates with the nut member (413) to drive the first cover (21) to move along the length direction.

5. The component (100) according to claim 4, **characterized in that** the first driving assembly (41) further comprises a limit switch (416), and when the first cover (21) moves along the length direction to one end (1113) of the opening and the first area (1111) is opened, the limit switch (416) is triggered to stop the motor (414).

6. The component (100) according to claim 1, **characterized in that** it further comprises a second driving assembly (42), comprising: a motor (421), a transmission assembly (422), the motor (421) and the transmission assembly (422) being arranged adjacent to each other in a height direction, and the motor (421) being mounted to the base (1) through a bracket (423); and the transmission assembly (422) comprising a first transmission wheel (4221), a transmission belt (4222), and a second transmission gear (4223), the second transmission gear (4223) being coaxially connected to a shaft (12), and the shaft (12) providing the axis (121), and an output rotation of the motor (421) being transmitted to the first transmission wheel (4221) by the transmission belt (4222), the first transmission wheel (4221) transmitting the rotation to the second transmission gear (4223) through gear meshing, to drive the second cover (22) to flip around the axis (121).

7. The component (100) according to claim 6, **characterized in that** the transmission assembly (422) further comprises an intermediate transmission gear (4224), and the first transmission wheel (4221) meshes with the intermediate transmission gear (4224), and the intermediate transmission gear (4224) meshes with the second transmission gear (4223).

8. The component (100) according to claim 6, **characterized in that** the second driving assembly (42) is provided on both sides of the width direction of the second cover (22).

9. The component (100) according to claim 1, **characterized in that** it further comprises a third driving assembly (43), the third driving assembly (43) being connected to the movable display device (3), the third driving assembly (43) comprising a first motor (431), a second motor (432), a first movable slide rail (433), and a second movable slide rail (434), the first motor (431) being able to drive the movable display device (3) to move to a first height in a height direction, the second motor (432) being able to drive the second movable slide rail (434) to a second height in the height direction relative to the first movable slide rail (433); and the third driving assembly (43) further comprises a third motor (435) and a fourth motor (436), the third motor (435) being connected to the movable display device (3) and being able to drive the movable display device (3) to rotate around an axis extending in the length direction, and the fourth motor (436) being connected to the movable display device (3) and being able to drive the movable display device (3) to rotate around an axis extending in a width direction.

10. A cockpit component, **characterized in that** it comprises the component (100) according to any one of claims 1 to 9, wherein the cockpit component comprises a center console, a seat, a door panel, and an instrument panel.
